# EUROPÄISCHE PATENTANMELDUNG

(11) **EP 3 190 437 A2**
(43) Veröffentlichungstag der Anmeldung: **12.07.2017**
(21) Anmeldenummer: 16203810.3
(22) Anmeldetag: 13.12.2016
(51) Int. Cl.: G02B 5/08, G03F 7/20, G21K 1/06

(54) **SPIEGEL ZUR REFLEXION VON EUV-STRAHLUNG IM SPEKTRALBEREICH ZWISCHEN 6 NM UND 10 NM UND OPTISCHE ANORDNUNG MIT DEM SPIEGEL**

(30) Priorität: 18.12.2015 DE 102015122300
(71) Anmelder: Fraunhofer-Gesellschaft zur Förderung der angewandten Forschung e.V., 80686 München (DE)
(72) Erfinder: Naujok, Philipp, 07745 Jena (DE); Yulin, Sergiy, 07745 Jena (DE); Kaiser, Norbert, 07745 Jena (DE); Von Wezyk, Alexander, 52074 Aachen (DE); Bergmann, Klaus, 52134 Herzogenrath (DE)
(74) Vertreter: Epping - Hermann - Fischer

(57) **Zusammenfassung**

Es wird ein Spiegel (10) zur Reflexion von EUV-Strahlung im Spektralbereich zwischen 6 nm und 10 nm beschrieben, der mindestens eine auf einem Substrat (1) angeordnete oxidationshemmende Schicht (2) umfasst, die ein Lanthanoxid, ein Ceriumoxid, ein Thoriumoxid, ein Uranoxid oder diamantartigen Kohlenstoff aufweist. Weiterhin wird eine optische Anordnung (100) beschrieben, die eine EUV-Strahlungsquelle (11) und mindestens einem derartigen Spiegel (10) aufweist.

## Beschreibung

Die Erfindung betrifft einen Spiegel, der zur Reflexion von extrem ultravioletter Strahlung (EUV-Strahlung) im Spektralbereich zwischen 6 nm und 10 nm geeignet ist, und eine optische Anordnung mit mindestens einem derartigen Spiegel.

Diese Patentanmeldung beansprucht die Priorität der deutschen Patentanmeldung 10 2015 122 300.7, deren Offenbarungsgehalt hiermit durch Rückbezug aufgenommen wird.

In diesem Wellenlängenbereich ist die Wellenlänge um 6,7 nm von besonderer Bedeutung, weil Strahlung dieser Wellenlänge in einer nächsten Generation der EUV-Lithographie (BEUVL, Beyond Extreme Ultraviolet Lithography) eingesetzt werden könnte.

Plasmabasierte Strahlungsquellen erlauben den Aufbau relativ kompakter und kostengünstiger Systeme für Anwendungen im EUV-Spektralbereich. Solche Plasmen werden entweder durch die Bestrahlung eines Targets mit intensiver gepulster Laserstrahlung oder in einer gepulsten Hochstromgasentladung erzeugt. Dabei wird das Target oder Betriebsgas soweit aufgeheizt, dass es zur Emission charakteristischer, kurzwelliger Strahlung angeregt wird.

Solche Strahlungsquellen emittieren das Licht näherungsweise isotrop. Für eine effektive Nutzung in einer Applikation ist daher ein optisches Element notwendig, mit dem das Licht aufgesammelt und fokussiert werden kann. Die Fokussierung erfolgt dann entweder direkt auf das zu bearbeitende oder zu bestrahlende Werkstück oder es wird in einem nachgeschalteten optischen System weiter genutzt, etwa zur Abbildung von Strukturen in einem Mikroskop oder zur Erzeugung von Strukturen in einem Resist. So sind zum Beispiel im Umfeld der Technologieentwicklung der EUV-Lithografie bei einer Arbeitswellenlänge von 13,5 nm entsprechende Systeme im Einsatz.

Plasmabasierte Strahlungsquellen emittieren neben der Strahlung auch Debris in Form von schnellen Ionen oder Neutralteilchen aus dem Target bzw. dem Elektrodenmaterial. Der Debris führt infolge von Abtrag durch schnelle Teilchen (Sputtern) oder Deposition von langsamen Teilchen auf der Oberfläche zur Degradation des Spiegels oder der Reduktion des Reflexionsgrades.

Eine zu lösende Aufgabe besteht somit darin, einen Spiegel zur Reflexion von EUV-Strahlung im Spektralbereich zwischen 6 nm und 10 nm und eine optische Anordnung mit mindestens einem solchen Spiegel anzugeben, wobei sich der mindestens eine Spiegel und die optische Anordnung durch eine verbesserte Stabilität gegenüber Degradation unter dem Einfluss der von einer EUV-Strahlungsquelle emittierten Ionen und/oder Neutralteilchen auszeichnen.

Diese Aufgaben werden durch einen Spiegel und eine optische Anordnung gemäß den unabhängigen Patentansprüchen gelöst. Vorteilhafte Ausgestaltungen und Weiterbildungen der Erfindung sind Gegenstand der abhängigen Ansprüche.

Der hier beschriebene Spiegel ist zur Reflexion von EUV-Strahlung im Spektralbereich zwischen 6 nm und 10 nm, vorzugsweise zwischen 6 nm und 7 nm, insbesondere bei etwa 6,7 nm, vorgesehen.

Der Spiegel umfasst mindestens eine auf einem Substrat angeordnete oxidationshemmende Schicht, die ein Lanthanoxid, ein Ceriumoxid, ein Thoriumoxid, ein Uranoxid oder diamantartigen Kohlenstoff (DLC, diamond like carbon) aufweist oder daraus besteht. Die oxidationshemmende Schicht muss nicht unmittelbar an das Substrat angrenzen, sondern es können eine oder mehrere weitere Schichten zwischen dem Substrat und der oxidationshemmenden Schicht angeordnet sein. Die oxidationshemmende Schicht ist insbesondere die äußerste Schicht auf der vom Substrat abgewandten Seite des Spiegels, also mit anderen Worten die Deckschicht des Spiegels.

Es hat sich herausgestellt, dass der Spiegel mit einer oxidationshemmenden Schicht, die ein Lanthanoxid, ein Ceriumoxid, ein Thoriumoxid, ein Uranoxid oder diamantartigen Kohlenstoff aufweist, eine vergleichsweise hohe Reflexion im EUV-Spektralbereich zwischen 6 nm und 10 nm aufweist. Gleichzeitig zeichnet sich der Spiegel mit der oxidationshemmenden Schicht als Deckschicht durch eine sehr geringe Anfälligkeit gegenüber Oxidation und gegenüber einer Schädigung durch auftreffende Teilchen (Sputtern) aus. Der Spiegel mit der oxidationshemmenden Schicht ist somit besonders oxidationsbeständig und erosionsbeständig, insbesondere unter dem Einfluss der Strahlung und der emittierten Ionen und Neutralteilchen einer EUV-Strahlungsquelle. Der Spiegel zeichnet sich daher durch eine verbesserte Langzeitstabilität beim Betrieb im Einflussbereich einer EUV-Strahlungsquelle aus.

Wenn die oxidationshemmende Schicht als Einzelschicht auf das Substrat aufgebracht ist, weist die Schicht vorzugsweise eine Dicke von mindestens 50 nm, vorzugsweise von 50 nm bis 100 nm, auf, um eine ausreichend hohe Reflektivität zu erzielen.

Bei einer bevorzugten Ausgestaltung des Spiegels ist zwischen dem Substrat und der oxidationshemmenden Schicht mindestens eine weitere Schicht angeordnet. Die weitere Schicht kann insbesondere Lanthan, Cerium, Thorium oder Uran aufweisen oder daraus bestehen. Diese Materialien zeichnen sich durch eine besonders hohe Reflexion im Spektralbereich von 6 nm bis 10 nm aus, sind aber nicht so stabil, wie die Oxide von La, Ce, U oder Th oder diamantartiger Kohlenstoff. Durch die darüber angeordnete oxidationshemmende Schicht zeichnet sich der Spiegel weiterhin durch eine hohe Beständigkeit gegenüber Oxidation auf. Die oxidationshemmende Schicht fungiert bei dieser Ausgestaltung als Schutzschicht. Die Dicke der oxidationshemmenden Schicht wird bei dieser Ausgestaltung vorteilhaft so dimensioniert, dass einerseits eine ausreichende Schutzwirkung vorliegt und andererseits eine möglichst hohe Reflexion erzielt wird. Die Dicke der oxidationshemmenden Schicht über der mindestens einen weiteren Schicht beträgt vorzugsweise zwischen 1 nm und 10 nm, insbesondere zwischen 1 nm und 5 nm.

Die mindestens eine weitere Schicht weist vorzugsweise eine Dicke zwischen 50 nm und 100 nm auf. Dies ermöglicht eine hohe Reflexion auch dann, wenn die darüber angeordnete oxidationshemmende Schicht vergleichsweise dünn ist.

Bei einer besonders bevorzugten Ausgestaltung weist die mindestens eine weitere Schicht ein Lanthannitrid, ein Lanthancarbid, ein Ceriumnitrid, ein Ceriumcarbid, ein Thoriumnitrid, ein Thoriumcarbid, ein Urannitrid oder ein Urancarbid auf oder besteht daraus. Die genannten Nitride und Carbide von La, Ce, Th und U zeichnen sich insbesondere durch eine hohe Beständigkeit gegen Erosion, also eine Schädigung durch Materialabtrag, aus. Durch die mindestens eine weitere Schicht, die ein Lanthannitrid, ein Lanthancarbid, ein Ceriumnitrid, ein Ceriumcarbid, ein Thoriumnitrid, ein Thoriumcarbid, ein Urannitrid oder ein Urancarbid aufweist, wird die Beständigkeit des Spiegels gegenüber Erosion durch auftreffende Ionen und/oder Neutralteilchen weiter verbessert.

Bei einer bevorzugten Ausgestaltung weist der Spiegel einen Schichtenstapel auf, der mehrere Schichtpaare aufweist. Die Schichtpaare enthalten jeweils eine erste Schicht und eine zweite Schicht und können insbesondere nur aus der ersten Schicht und der zweiten Schicht bestehen.

Die erste Schicht der Schichtpaare entspricht hinsichtlich der Materialien und der vorteilhaften Eigenschaften der zuvor beschriebenen weiteren Schicht und die zweite Schicht der Schichtpaare entspricht hinsichtlich der Materialien und der vorteilhaften Eigenschaften der zuvor beschriebenen oxidationshemmenden Schicht. Insbesondere weist der Schichtenstapel eine zweite Schicht, also eine oxidationshemmende Schicht, als Deckschicht auf.

Die erste Schicht der Schichtpaare kann gemäß einer Ausgestaltung Lanthan, Thorium oder Uran aufweisen. Bevorzugt weist die erste Schicht ein Lanthannitrid, ein Lanthancarbid, ein Ceriumnitrid, ein Ceriumcarbid, ein Thoriumnitrid, ein Thoriumcarbid, ein Urannitrid oder ein Urancarbid auf oder besteht daraus. Die erste Schicht kann also insbesondere eines der Materialien enthalten, die wie zuvor beschrieben für die mindestens eine weitere Schicht zwischen dem Substrat und der oxidationshemmenden Schicht infrage kommen und sich durch eine besonders gute Beständigkeit gegenüber Erosion durch auftreffende Ionen oder Neutralteilchen auszeichnen.

Die zweite Schicht der Schichtpaare enthält bevorzugt ein Lanthanoxid, ein Ceriumoxid, ein Thoriumoxid, ein Uranoxid oder diamantartigen Kohlenstoff oder besteht daraus. Die zweite Schicht der Schichtpaare kann demnach insbesondere eines der Materialien enthalten, die als oxidationshemmende Schicht geeignet sind. Diese Materialien zeichnen sich durch eine besonders hohe Beständigkeit gegenüber Oxidation auf. Die Deckschicht des Schichtenstapels ist bevorzugt eine zweite Schicht, so dass der Spiegel nach außen durch die oxidationshemmende Schicht geschützt ist.

Die Verwendung eines Schichtenstapels aus abwechselnden ersten und zweiten Schichten, die sich durch jeweils eine gute Oxidations- oder Erosionsbeständigkeit gegenüber auftreffenden Ionen oder Neutralteilchen auszeichnet, hat gegenüber einem Spiegel, der nur die oxidationshemmende Schicht und ggf. eine weitere Schicht aufweist, den Vorteil, dass eine Vielzahl von Grenzflächen eine Oxidation und/oder Erosion behindert. Der Spiegel mit dem Schichtenstapel zeichnet sich daher durch eine besonders gute Oxidations- und Erosionsbeständigkeit aus. Der Schichtenstapel kann bei einer vorteilhaften Ausgestaltung mehr Schichtpaare enthalten, als aufgrund der begrenzten Eindringtiefe der Strahlung zur Reflexion beitragen. In diesem Fall vermindert sich die Reflexion auch dann nicht wesentlich, wenn an der Oberfläche des Spiegels ein oder mehrere Schichten durch Erosion (Materialabtrag) geschädigt werden und deshalb ganz oder teilweise verloren gehen.

Der Schichtenstapel kann insbesondere ein periodischer Schichtenstapel sein, bei dem die Schichtpaare jeweils die gleiche Dicke (Periodendicke) aufweisen. Da der Spiegel für die Verwendung unter streifendem Einfall vorgesehen ist, muss die Periodendicke nicht an die Wellenlänge angepasst sein. Hierin unterscheidet sich der Spiegel von typischerweise unter senkrechtem Einfall verwendeten EUV-Spiegeln, bei denen die Periodendicke in etwa die Hälfte der Wellenlänge beträgt. Der Schichtenstapel muss auch nicht notwendigerweise periodisch sein, d.h. die Dicke der Schichtpaare in dem Schichtenstapel kann voneinander abweichen.

Die ersten Schichten und die zweiten Schichten der Schichtpaare weisen vorzugsweise jeweils eine Dicke zwischen 1 nm und 10 nm auf. Die Anzahl der Schichtpaare in dem Schichtenstapel beträgt vorzugsweise zwischen 5 und 20, beispielsweise etwa 10.

Es wird weiterhin eine optische Anordnung mit mindestens einem wie zuvor beschriebenen Spiegel angegeben. Die optische Anordnung umfasst eine Strahlungsquelle, die zur Emission von EUV-Strahlung mit einer Wellenlänge zwischen 6 nm und 10 nm geeignet ist. Weiterhin umfasst die optische Anordnung mindestens ein strahlformendes Element, das den mindestens einen Spiegel aufweist.

Die EUV-Strahlungsquelle ist vorzugsweise eine Plasma-Strahlungsquelle. Die EUV-Strahlungsquelle kann insbesondere eine entladungsbasierte Strahlungsquelle sein, die ein Elektrodensystem zur Erzeugung eines Plasmas aufweist. In einer solchen entladungsbasierten Strahlungsquelle wird durch einen gepulsten elektrischen Strom einer Entladung ein Gas so stark verdichtet und aufgeheizt, dass EUV-Strahlung emittiert wird. Zur Erzeugung von EUV-Strahlung im Wellenlängenbereich zwischen 6 und 10 nm ist insbesondere Krypton als Arbeitsgas geeignet. Das durch eine elektrische Entladung in der Strahlungsquelle erzeugte Krypton-Plasma kann beispielsweise Strahlung mit einer Leistung von 50 W oder mehr im Bereich 6-10 nm in den Halbraum emittieren. Durch ein strahlformendes Element, das einen Öffnungswinkel von beispielsweise etwa 45° gegen die optische Achse aufweist, kann Strahlung mit einer Leistung von etwa 15 W gesammelt werden.

Die von der Strahlungsquelle emittierte EUV-Strahlung trifft vorteilhaft zum überwiegenden Teil, insbesondere zu mehr als 50 % oder vorzugsweise mehr als 75 % in einem Winkelbereich zwischen 0° und 20° bezogen auf die Oberfläche des Spiegels auf den mindestens einen Spiegel des strahlformenden Elements auf. Mit anderen Worten wird das strahlformende Element unter streifendem Einfall (gracing incidence) verwendet. Der angegebene Winkelbereich zwischen 0° und 20° bezieht sich auf den Winkel relativ zur Oberfläche des Spiegels, der auch als Streifwinkel (gracing angle) bezeichnet wird. Der Streifwinkel wird anders als der allgemein in der Optik verwendete Einfallswinkel nicht zum Lot, sondern relativ zur Oberfläche gemessen.

Das strahlformende Element ist vorzugsweise zur Fokussierung der EUV-Strahlung ausgelegt. Die EUV-Strahlung wird durch das strahlformende Element also vorzugsweise in einen Brennpunkt oder in eine Brennebene abgebildet.

Gemäß einer bevorzugten Ausgestaltung ist das strahlformende Element eine Wolter-Optik, insbesondere ein Wolter-Mehrschalenkollektor. Eine Wolter-Optik basiert auf Spiegeln, die Strahlung unter streifendem Einfall reflektieren. Da ein einzelner Spiegel unter streifendem Einfall nur einen kleinen Teil der einfallenden Strahlung einfangen kann, enthält eine Wolter-Optik in der Regel eine Vielzahl ineinander geschachtelter Spiegel. Das als Wolter-Optik ausgeführte strahlformende Element kann insbesondere mehrere konzentrische rotationssymmetrische Spiegel aufweisen. Die Spiegel sind vorzugsweise konzentrisch zu einer optischen Achse ineinander geschachtelt. Die Spiegel reflektieren vorteilhaft jeweils EUV-Strahlung unter streifendem Einfall mit Winkeln von überwiegend weniger als 20° gemessen zur Oberfläche des jeweiligen Spiegels.

Der mindestens eine Spiegel weist vorzugsweise zumindest bereichsweise eine parabolische, elliptische oder hyperbolische Form auf. Alternativ kann der Spiegel auch als Freiformfläche mit einer beliebigen an die jeweilige Anwendung angepassten Oberflächenform ausgebildet sein. Das strahlformende Element kann insbesondere durch eine Kombination mehrerer Spiegel gebildet sein.

Gemäß zumindest einer Ausgestaltung enthält die optische Anordnung weiterhin eine Vorrichtung zur Verminderung von Debris der EUV-Strahlungsquelle. Unter dem Begriff "Debris" sind hierbei von der EUV-Strahlungsquelle emittierte Ionen oder Neutralteilchen zu verstehen. Die Emission solcher Ionen und Neutralteilchen ist in der Regel ein unerwünschter Nebeneffekt bei der Erzeugung von EUV-Strahlung mittels einer Plasmaquelle, da die emittierten Ionen oder Neutralteilchen zu einer Verunreinigung oder Schädigung der optischen Komponenten der optischen Anordnung führen können.

Bei der hierin beschriebenen optischen Anordnung wird vorteilhaft der zuvor beschriebene Spiegel verwendet, der vergleichsweise unempfindlich gegen eine Schädigung durch Debris ist. Zusätzlich ist es aber hilfreich, dass Auftreffen von Debris auf das strahlformende Element durch die Vorrichtung zur Verminderung des Debris zu vermindern. Hierzu weist die Vorrichtung zur Verminderung von Debris vorzugsweise eine Folienfalle auf. In der Folienfalle kann sich zumindest bereichsweise ein Gas, insbesondere ein Edelgas wie beispielsweise Xenon oder Argon, befinden, um schwere Teilchen aus dem Plasma wie zum Beispiel Krypton, Gadolinium oder Terbium durch Stöße abzubremsen.

Gemäß einer weiteren vorteilhaften Ausgestaltung enthält die optische Anordnung einen Spektralfilter zur Unterdrückung von sichtbarem Licht und/oder Strahlung anderer Wellenlängen, die außerhalb des relevanten EUV-Strahlungsbereichs liegen. Der Spektralfilter kann zu diesem Zweck insbesondere eine Folie aufweisen, die mindestens eines der Materialien Zinn, Borcarbid, Cerium oder Lanthan aufweist.

Die Erfindung wird im Folgenden anhand von Ausführungsbeispielen im Zusammenhang mit den Figuren 1 bis 7 näher erläutert.

Es zeigen:
Figur 1 eine schematische Darstellung eines Spiegels für EUV-Strahlung gemäß einem Ausführungsbeispiel,
Figur 2 eine graphische Darstellung der Reflexion von Spiegeln für EUV-Strahlung gemäß verschiedenen Ausführungsbeispielen,
Figur 3 eine schematische Darstellung eines Spiegels für EUV-Strahlung gemäß einem weiteren Ausführungsbeispiel,
Figur 4 eine graphische Darstellung der Reflexion von Spiegeln für EUV-Strahlung gemäß verschiedenen Ausführungsbeispielen,
Figur 5 eine schematische Darstellung eines Spiegels für EUV-Strahlung gemäß einem weiteren Ausführungsbeispiel,
Figur 6 eine graphische Darstellung der Reflexion von Spiegeln für EUV-Strahlung gemäß verschiedenen Ausführungsbeispielen, und
Figur 7 eine optische Anordnung gemäß einem
   Ausführungsbeispiel, die mehrere Spiegel für EUV-Strahlung aufweist.

Gleiche oder gleich wirkende Bestandteile sind in den Figuren jeweils mit den gleichen Bezugszeichen versehen. Die dargestellten Bestandteile sowie die Größenverhältnisse der Bestandteile untereinander sind nicht als maßstabsgerecht anzusehen.

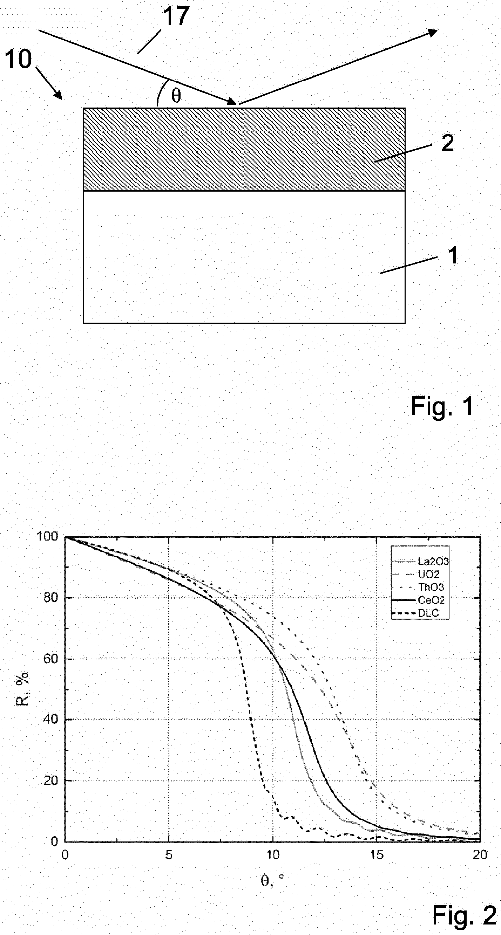

Der in Figur 1 schematisch im Querschnitt dargestellte Spiegel 10 für EUV-Strahlung weist ein Substrat 1 und eine auf dem Substrat angeordnete oxidationshemmende Schicht 2 auf. Das Substrat 1 kann insbesondere ein Grundkörper eines strahlformenden optischen Elements sein. Die Oberfläche des Substrats 1 kann eben oder gekrümmt sein. Das Substrat 1 wird vorzugsweise vor einer Beschichtung mit der
oxidationshemmende Schicht 2 gemäß den Anforderungen der Anwendung des Spiegels 10 hinsichtlich der Oberflächenform und Oberflächenrauheit bearbeitet.

Die oxidationshemmende Schicht 2 ist durch ein Beschichtungsverfahren auf die Oberfläche des Substrats 1 aufgebracht. Die Beschichtung des Substrats 1 kann insbesondere durch Sputtern erfolgen, wobei alternativ aber auch andere Beschichtungsverfahren eingesetzt werden können.

Der Spiegel 10 ist zur Reflexion von EUV-Strahlung 17 im Wellenlängenbereich von 6 nm bis 10 nm unter streifendem Einfall vorgesehen. Der zur Oberfläche des Spiegels 10 gemessene Streifwinkel θ (gracing angle), unter dem die EUV-Strahlung auf den Spiegel 10 auftrifft, beträgt vorzugsweise zwischen 0° und 20°.

Die auf das Substrat aufgebrachte oxidationshemmende Schicht 2 weist vorteilhaft ein Lanthanoxid (LaOₓ), ein Ceriumoxid (CeOₓ), ein Thoriumoxid (ThOₓ), ein Uranoxid (UOₓ) oder diamantartigem Kohlenstoff auf. Diese Materialien zeichnen sich durch eine hohe Reflexion in dem Wellenlängenbereich von 6 nm bis 10 nm und gleichzeitig eine hohe Stabilität gegenüber Oxidation und Erosion durch von einer EUV-Strahlungsquelle emittierte Ionen oder Neutralteilchen aus. Der Spiegel 10 zeichnet sich daher durch eine hohe Stabilität in der Umgebung einer EUV-Strahlungsquelle aus.

In Figur 2 ist die berechnete Reflexion R in Abhängigkeit von dem Streifwinkel θ für s-polarisierte Strahlung mit einer Wellenlänge λ= 6,7 nm für verschiedene Ausführungsbeispiele des Spiegels gemäß Figur 1 dargestellt. Die dargestellten Ausführungsbeispiele weisen eine jeweils 100 nm dicke oxidationshemmende Schicht 2 auf einem Substrat 1 auf, wobei die oxidationshemmende Schicht 2 La₂O₃, CeO₂, UO₂, ThO₃ oder DLC aufweist.

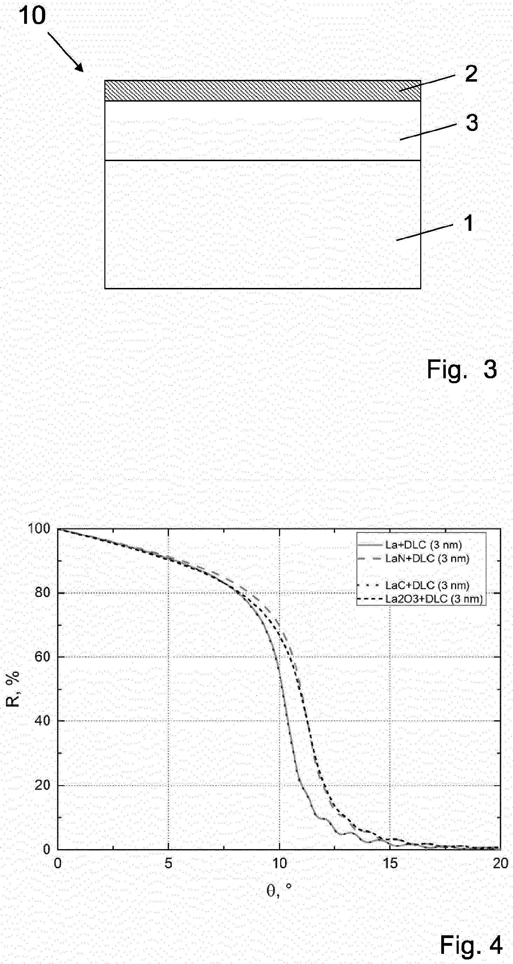

In Figur 3 ist ein weiteres Ausführungsbeispiel des Spiegels für EUV-Strahlung dargestellt, bei dem zwischen dem Substrat 1 und der oxidationshemmenden Schicht 2 eine weitere Schicht 3 angeordnet ist. Wie bei dem vorherigen Ausführungsbeispiel weist die oxidationshemmende Schicht 2 vorteilhaft ein Lanthanoxid (LaOₓ), ein Ceriumoxid (CeOₓ), ein Thoriumoxid (ThOₓ), ein Uranoxid (UOₓ) oder diamantartigem Kohlenstoff auf und schützt den Spiegel 10 insbesondere vor Oxidation und Erosion durch auftreffende Teilchen.

Die weitere Schicht 3 zwischen dem Substrat 1 und der oxidationshemmenden Schicht 2 enthält gemäß einer Ausgestaltung Lanthan, Cerium, Thorium oder Uran. Mit diesen Materialien lässt sich eine hohe Reflexion im relevanten EUV-Spektralbereich von 6 nm bis 10 nm erzielen. Bei einer besonders bevorzugten Ausgestaltung enthält die weitere Schicht 3 ein Lanthannitrid (LaNₓ), ein Lanthancarbid (LaCₓ), ein Ceriumnitrid (CeNₓ), ein Ceriumcarbid (CeCₓ), ein Thoriumnitrid (ThNₓ), ein Thoriumcarbid (ThCₓ), ein Urannitrid (UNₓ) oder ein Urancarbid (UCₓ) oder besteht aus einem dieser Materialien. Die genannten Nitride und Carbide von La, Ce, Th und U zeichnen sich durch eine besonders gute Erosionsbeständigkeit bei gleichzeitig hoher Reflexion aus.

Die oxidationshemmende Schicht 2 kann bei der Anordnung mindestens einer weiteren Schicht 3 zwischen dem Substrat 1 und der oxidationshemmenden Schicht 2 vergleichsweise dünn ausgeführt werden. Die Dicke der oxidationshemmenden Schicht 3 beträgt vorzugsweise zwischen 1 nm und 10 nm, besonders bevorzugt zwischen 1 nm und 5 nm, beispielsweise etwa 3 nm. Die mindestens eine weitere Schicht 3 ist vorzugsweise zwischen 50 nm und 100 nm dick.

In Figur 4 ist die berechnete Reflexion R in Abhängigkeit vom Streifwinkel θ für s-polarisierte Strahlung mit einer Wellenlänge λ = 6,7 nm für verschiedene Ausführungsbeispiele des Spiegels gemäß Figur 3 dargestellt. Die dargestellten Ausführungsbeispiele weisen jeweils eine 3 nm dicke oxidationshemmende Schicht 2 aus diamantartigem Kohlenstoff auf. Die weitere Schicht 3 ist jeweils 100 nm dick und besteht aus La, LaN, LaC oder La₂O₃.

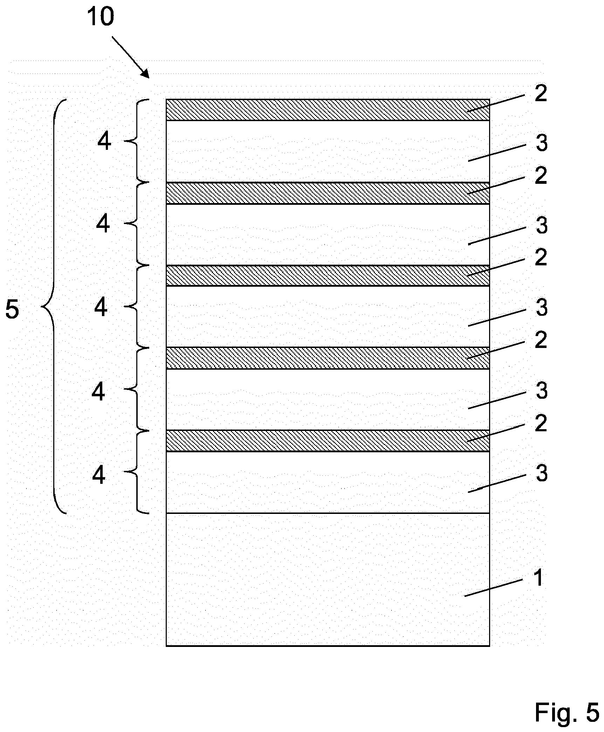

In Figur 5 ist ein weiteres Ausführungsbeispiel des Spiegels 10 für EUV-Strahlung dargestellt. Bei diesem Ausführungsbeispiel weist der Spiegel 10 einen Schichtenstapel 5 auf, der Schichtpaare 4 aus jeweils einer weiteren Schicht 3 und einer oxidationshemmenden Schicht 2 aufweist. Die vorteilhaften Ausgestaltungen der weiteren Schicht 3 und der oxidationshemmenden Schicht 2 in den Schichtpaaren entsprechen den zuvor beschriebenen Ausführungsbeispielen. Bei dem dargestellten Ausführungsbeispiel ist der Schichtenstapel ein periodischer Schichtenstapel, der beispielsweise fünf Perioden aufweist. Durch die abwechselnde Anordnung der oxidationshemmenden Schichten 2 und der weiteren Schichten 3 in einem Schichtenstapel 5 wird ein besonders oxidations- und erosionsbeständiger Spiegel 10 erzielt. Die weiteren Schichten 3 sind in dem Schichtstapel 5 vorzugsweise dicker als die oxidationshemmenden Schichten 2, um eine besonders hohe Reflektivität zu erzielen. Vorzugsweise sind die weiteren Schichten 3 mehr als 5 nm dick und die oxidationshemmenden Schichten 2 weniger als 5 nm dick.

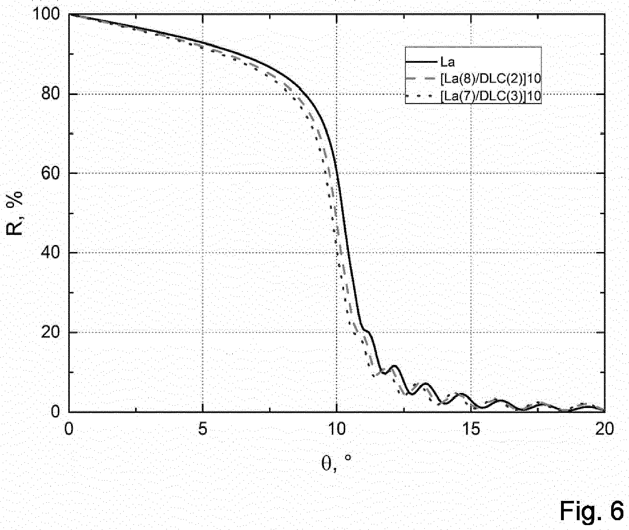

In Figur 6 ist die berechnete Reflexion R in Abhängigkeit vom Streifwinkel θ für s-polarisierte Strahlung mit einer Wellenlänge λ= 6,7 nm für zwei Ausführungsbeispiele des Spiegels gemäß Figur 5 und ein nicht anspruchsgemäßes Vergleichsbeispiel dargestellt. Die Ausführungsbeispiele weisen einen periodischen Schichtenstapel 5 mit zehn Schichtpaaren 4 aus einer Lanthanschicht 3 und einer oxidationshemmenden Schicht 2 aus diamantartigem Kohlenstoff auf. Die Periodendicke beträgt 10 nm, wobei bei einem ersten Beispiel die Lanthanschicht 3 eine Dicke von 8 nm und die diamantartige Kohlenstoffschicht 2 eine Dicke von 2 nm aufweist. Bei einem zweiten dargestellten Beispiel weist die Lanthanschicht 3 eine Dicke von 7 nm und die diamantartige Kohlenstoffschicht 2 eine Dicke von 3 nm auf. Zum Vergleich ist die Reflexion einer nicht anspruchsgemäßen 100 nm dicken Einzelschicht aus Lanthan dargestellt.

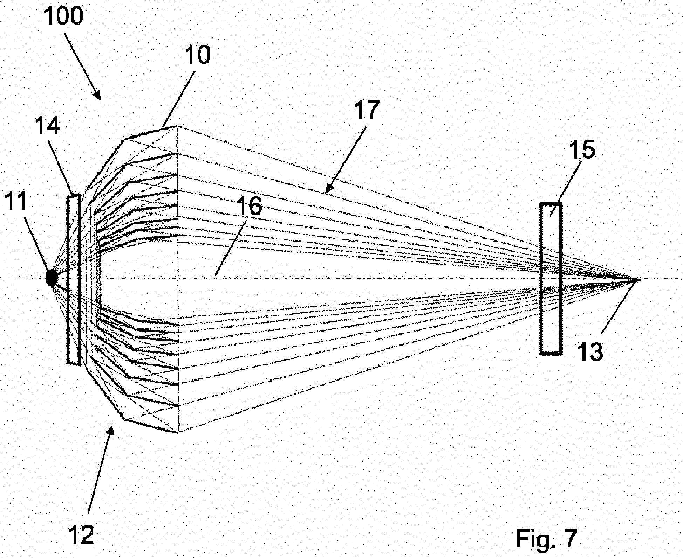

Die Figur 7 zeigt schematisch eine optische Anordnung 100, die von dem zuvor beschriebenen Spiegel Gebrauch macht. Die optische Anordnung 100 ist bei dem Ausführungsbeispiel ein Belichtungssystem, das von einer EUV-Strahlungsquelle 11 emittierte Strahlung in einen Brennpunkt 13 abbildet. Die EUV-Strahlungsquelle 11 kann beispielsweise eine entladungsbasierte Plasmaquelle sein. In der EUV-Strahlungsquelle 11 wird zum Beispiel ein Krypton-Plasma erzeugt, dass unter anderem Strahlung im Spektralbereich von 6 nm bis 10 nm emittiert. Die von der EUV-Strahlungsquelle 11 emittierte EUV-Strahlung 17 wird mittels eines strahlformenden Elements 12 in den Brennpunkt 13 abgebildet. Das strahlformende Element 12 ist bei dem dargestellten Ausführungsbeispiel eine Wolter-Optik, insbesondere ein Wolter-Mehrschalenkollektor. Das strahlformende Element 12 weist insbesondere mehrere ineinander geschachtelte Spiegel 10 auf, die vorzugsweise konzentrisch um eine gemeinsame optische Achse 16 angeordnet sind.

Die mehreren Spiegel 10 des strahlformenden Elements 12 sind jeweils EUV-Spiegel, die vorteilhaft wie der zuvor im Zusammenhang mit den Ausführungsbeispielen der Figuren 1 bis 6 beschriebene Spiegel 10 ausgebildet sind. Insbesondere weisen die Spiegel 10 jeweils ein Substrat und eine darauf aufgebrachte reflektierende oxidations- und erosionsbeständige Beschichtung gemäß diesen Ausführungsbeispielen auf.

Die EUV-Strahlung 17 wird an den mehreren Spiegeln 10 des strahlformenden Elements 12 jeweils unter streifendem Einfall reflektiert, wobei der Streifwinkel θ der jeweils auf die Spiegel 10 einfallenden Strahlung zum überwiegenden Teil im Bereich zwischen 0° und 20°, besonders bevorzugt im Bereich zwischen 0° und 10°, liegt. Es kann vorgesehen sein, dass an den Spiegeln 10 eine zweifache Reflexion unter streifendem Einfall erfolgt. Die Spiegel 10 können zumindest bereichsweise gekrümmt ausgeführt sein. Insbesondere können die Spiegel zumindest bereichsweise parabolisch, elliptisch, hyperbolisch oder als Freiformfläche geformt sein.

Die optische Anordnung 100 umfasst weiterhin vorteilhaft einen Spektralfilter 15, um spektrale Anteile außerhalb des Wellenlängenbereichs von 6 nm bis 10 nm zu unterdrücken. Geeignete Spektralfilter sind insbesondere Folien aus Sn, B4C, Zr, Ce oder La oder Kombinationen davon. Weiterhin kann auch Xenon, das beispielsweise als Gas in eine Vakuumkammer der optischen Anordnung eingebracht wird, als Spektralfilter zur Unterdrückung von EUV-Strahlung außerhalb des hier relevanten Wellenlängenbereichs von 6 nm bis 10 nm eingesetzt werden.

Weiterhin enthält die optische Anordnung 100 vorteilhaft eine Vorrichtung 14 zur Verminderung von Debris. Die Vorrichtung 14 ist vorteilhaft zwischen der EUV-Strahlungsquelle 11 und dem strahlformenden Element 12 angeordnet, um das Auftreffen von Ionen oder Neutralteilchen aus der EUV-Strahlungsquelle auf die Spiegel 10 des strahlformenden Elements 12 zu vermindern. Die Vorrichtung 14 kann insbesondere eine Folienfalle zum Abbremsen der aus der EUV-Strahlungsquelle 11 emittierten Ionen oder Neutralteilchen sein. Eine solche Folienfalle 14 ist im Zusammenhang mit einer EUV-Strahlungsquelle an sich bekannt und kann insbesondere lamellenartig angeordnete Folien aufweisen, welche aus der EUV-Strahlungsquelle emittierte Teilchen auffangen.

Im Bereich der Folienfalle kann vorteilhaft ein Gas wie zum Beispiel Xenon oder Argon zugeführt werden, wobei die Gasatome die emittierten Ionen oder Atome aus der EUV-Strahlungsquelle durch Stöße abbremsen. Für den vorliegenden Anwendungsfall wird insbesondere Xenon in Verbindung mit der Folienfalle verwendet. Die schweren Xenonatome bremsen schwere Teilchen aus dem Plasma wie zum Beispiel Krypton, Gadolinium oder Terbium besonders effektiv. Bei der Verwendung leichterer Elemente als Strahlungsquelle kann die Verwendung eines leichteren Stoßpartners in der Folienfalle vorteilhaft sein, insbesondere die Verwendung von Argon. Weiterhin ist es auch denkbar, Magnetfelder zur Ablenkung oder zum Abbremsen geladener Teilchen aus dem Plasma der EUV-Strahlungsquelle 11 einzusetzen.

Die EUV-Strahlungsquelle 11 kann beispielsweise Strahlung mit einer Strahlungsleistung von mehr als 50 W im Wellenlängenbereich von 6 nm bis 10 nm in einen Halbraum emittieren. Durch das strahlformende Element 12, das hier exemplarisch als Wolters-Mehrschalenkollektor ausgeführt ist, kann beispielsweise bei einem technisch realisierbaren Öffnungswinkel von etwa 45° eine Strahlungsleistung von ca. 15 W gesammelt werden. Es sind allerdings Verluste durch die Vorrichtung 14 zur Verminderung des Debris, eine Reflektivität der Spiegel 10 von weniger als 100 % sowie Verluste durch den Spektralfilter 15 zu berücksichtigen. Durch diese Verluste kann die Strahlung etwa um einen Faktor 3 bis 5 geschwächt werden. Unter Berücksichtigung dieser Verluste kann noch eine Strahlungsleistung von etwa 3 W bis 5 W im Fokus 13 erzielt werden.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

### Bezugszeichenliste

- 1: Substrat
- 2: oxidationshemmende Schicht
- 3: weitere Schicht
- 4: Schichtpaar
- 5: Schichtenstapel
- 10: Spiegel
- 11: EUV-Strahlungsquelle
- 12: Strahlformungselement
- 13: Brennpunkt
- 14: Vorrichtung zur Verminderung von Debris
- 15: Spektralfilter
- 16: optische Achse
- 17: EUV-Strahlung
- 100: optische Anordnung

## Patentansprüche

1. Spiegel (10) zur Reflexion von EUV-Strahlung (17) im Spektralbereich zwischen 6 nm und 10 nm, umfassend mindestens eine auf einem Substrat (1) angeordnete oxidationshemmende Schicht (2), die ein Lanthanoxid, ein Ceriumoxid, ein Thoriumoxid, ein Uranoxid oder diamantartigen Kohlenstoff aufweist, wobei die oxidationshemmende Schicht (2) als Einzelschicht auf das Substrat (1) aufgebracht ist und eine Dicke von 50 nm bis 100 nm aufweist, oder wobei zwischen dem Substrat (1) und der oxidationshemmenden Schicht (2) mindestens eine weitere Schicht (3) angeordnet ist, die eine Dicke von 50 nm bis 100 nm aufweist.

2. Spiegel nach Anspruch 1,
wobei die mindestens eine weitere Schicht (3) Lanthan, Cerium, Uran oder Thorium aufweist.

3. Spiegel einem der vorhergehenden Ansprüche,
wobei die mindestens eine weitere Schicht (3) ein Lanthannitrid, ein Lanthancarbid, ein Ceriumnitrid, ein Ceriumcarbid, ein Thoriumnitrid, ein Thoriumcarbid, ein Urannitrid oder ein Urancarbid aufweist.

4. Spiegel nach einem der vorhergehenden Ansprüche,
der die weitere Schicht (3) zwischen dem Substrat und der oxidationshemmende Schicht (2) enthält, wobei die oxidationshemmende Schicht (2) eine Dicke von 1 nm bis 10 nm aufweist.

5. Spiegel nach einem der vorhergehenden Ansprüche, umfassend einen Schichtenstapel (5), der mehrere Schichtpaare (4) aufweist, die jeweils eine erste Schicht und eine zweite Schicht enthalten, wobei die erste Schicht die weitere Schicht (3) ist, und die zweite Schicht die oxidationshemmende Schicht (2) ist.

6. Spiegel nach Anspruch 5,
wobei die ersten Schichten und die zweiten Schichten jeweils eine Dicke von 1 nm bis 10 nm aufweisen.

7. Optische Anordnung (100) mit mindestens einem Spiegel (10) nach einem der vorhergehenden Ansprüche, umfassend eine EUV-Strahlungsquelle (11), die zur Emission von EUV-Strahlung (17) mit einer Wellenlänge zwischen 6 nm und 10 nm geeignet ist, und mindestens ein strahlformendes Element (12), dass den mindestens einen Spiegel (10) aufweist,
wobei die von der EUV-Strahlungsquelle (11) emittierte EUV-Strahlung (17) zum überwiegenden Teil in einem Winkelbereich zwischen 0° und 20° bezogen auf die Oberfläche des Spiegels (10) auf den mindestens einen Spiegel (10) auftrifft.

8. Optische Anordnung nach Anspruch 7,
wobei das strahlformende Element (12) zur Fokussierung der EUV-Strahlung (17) eingerichtet ist.

9. Optische Anordnung nach einem der Ansprüche 7 oder 8,
wobei das strahlformende Element (12) eine Wolter-Optik ist.

10. Optische Anordnung nach einem der Ansprüche 7 bis 9, wobei der mindestens eine Spiegel (10) zumindest bereichsweise eine parabolische, elliptische oder hyperbolische Form oder eine Freiform aufweist.

11. Optische Anordnung nach einem der Ansprüche 7 bis 10, wobei die optische Anordnung (100) einen Spektralfilter (15) zur Unterdrückung von Strahlung außerhalb des Wellenlängenbereichs von 6 nm bis 10 nm aufweist, und wobei der Spektralfilter (15) eine Folie aufweist, die mindestens eines der Materialien Zinn, Borcarbid, Cerium oder Lanthan aufweist.
